# EUROPEAN PATENT APPLICATION

(11) **EP 4 644 313 A1**
(43) Date of publication of application: **05.11.2025**
(21) Application number: 24173119.9
(22) Date of filing: 29.04.2024
(51) Int. Cl.: B81B 7/00, B81B 7/02

(54) **MEMS SENSOR DEVICE AND SENSING METHOD**

(71) Applicant: Infineon Technologies AG, 85579 Neubiberg (DE)
(72) Inventor: HÄNSLER, Markus, 8081 Heiligenkreuz am Waasen (AT); BOGNER, Andreas, 80797 München (DE); GREINER, Philipp, 8053 Graz (AT); WIESBAUER, Andreas, 9210 Pörtschach (AT)
(74) Representative: 2SPL Patentanwälte PartG mbB

(57) **Abstract**

Provided is a MEMS sensor device (100; 200), comprising at least one micro-mechanical sensing element (110) and measurement circuitry (120; 510; 520; 530) coupled to the at least one micro-mechanical sensing element (110). The measurement circuitry (120; 510; 520; 530) is configured to, during a first operational mode of the MEMS sensor device (100; 200), control the at least one micro-mechanical sensing element (110) to measure a first physical parameter, and, during a second operational mode of the MEMS sensor device (100; 200), control the at least one micro-mechanical sensing element (110) to measure a different second physical parameter.

## Description

### Field

The present disclosure generally relates to MEMS (MicroElectroMechanical Systems) sensors, and, more particularly to MEMS sensors for sensing multiple physical parameters with existing MEMS sensor structures.

### Background

A MEMS sensor is a small-scale device combining mechanical and electrical components that work together to perform specific functions, often including sensing and actuation tasks. These devices may be fabricated using integrated circuit (IC) batch processing techniques and can range in size from a few micrometers to several millimeters.

MEMS sensors may operate on the principle of detecting changes in a measured physical quantity or parameter and converting it into an electrical signal. The physical parameters they can measure include pressure, acceleration, gyroscopic movements, and more, making them versatile and useful across various applications.

Benefits of MEMS sensors include their small size, low power consumption, high reliability, and cost-effectiveness. Due to these advantages, MEMS sensors may be widely used in numerous applications such as automotive systems (e.g., airbag sensors, tire pressure monitoring systems), consumer electronics (e.g., smartphones, tablets for motion sensing), medical devices (e.g., disposable blood pressure sensors), and industrial controls.

Waterproof MEMS sensors may be designed to operate reliably in environments where they may be exposed to water or other liquids. Waterproofing may be crucial for MEMS sensors used in applications where moisture or direct contact with water is expected, such as in underwater exploration, outdoor environmental monitoring, sports and fitness devices, and certain industrial processes.

To make MEMS sensors waterproof, manufacturers may employ several strategies. For example, the sensor may be enclosed in a waterproof material or casing that prevents water from reaching the sensitive electronic and mechanical components. This packaging must also allow the sensor to perform its measuring function accurately, which can be challenging for sensors that measure parameters such as pressure or sound. Another option is to apply hydrophobic (water-repellent) coatings or parylene coatings to the sensor surface can protect against moisture without significantly affecting the sensor's functionality. Hermetic sealing involves sealing the sensor in a way that is completely airtight (hermetic), using materials and seals that are impermeable to water.

For example, waterproof sensors may be covered by a thin layer of gel to protect the sensor (MEMS as well as ASIC) against environmental influence. Nevertheless, information if any materials (like water) are in contact with the gel may be of importance since it can impact the sensors accuracy. Conventionally, additional electrodes may be placed as close as possible to potential material by adding additional structures to the sensor which act as electrodes. These structures can also be outside the sensor. However, such structures may require a lot a space which is crucial, especially for area restricted sensors.

Thus, there is a demand for improved concepts for sensors capable of sensing if any materials are in contact with or in proximity to casings or coatings or the sensor.

### Summary

This demand is addressed by the appended claims.

According to a first aspect, the present disclosure provides a MEMS sensor device. The MEMS sensor device comprises at least one micro-mechanical sensing element and measurement circuitry coupled to the at least one micro-mechanical sensing element. The measurement circuitry is configured to, during a first operational mode of the MEMS sensor device, control the at least one micro-mechanical sensing element to measure a first physical parameter, and, during a second operational mode of the MEMS sensor device, control the at least one micro-mechanical sensing element to measure a different second physical parameter.

In this way, existing MEMS structures of the MEMS sensor device (for example, pressure sensor) may be reused as electrodes for material sensing, e.g., sensing if any materials are in contact with or in proximity to casings or coatings or the MEMS sensor device. The structures do not need to be additional dedicated structures (like metal electrodes). Existing sensor structures like poly membranes can be reused. This avoids additional structures on the MEMS sensor device as well as bond wires (area and cost improvements).

In some embodiments, the measurement circuitry is configured to, during the first operational mode, electrically connect the at least one micro-mechanical sensing element in accordance with a first electrical connection to measure the first physical parameter using the micro-mechanical sensing element, and, during the second operational mode, electrically connect the at least one micro-mechanical sensing element in accordance with a different second electrical connection to measure the second physical parameter using the micro-mechanical sensing element. The different electrical connections of the micro-mechanical sensing element may enable measuring different physical quantities or parameters with the same micro-mechanical sensing element.

In some embodiments, the measurement circuitry is configured to, during the first operational mode, measure one of acceleration, pressure, motion, magnetic field, or sound as the first physical parameter, and, during the second operational mode, measure a presence or absence of a material in proximity to the MEMS sensor device as the second physical parameter. For example, the material comprises a liquid, in particular water. This, the at least one micro-mechanical sensing element may be used to measure one of acceleration, pressure, motion, magnetic field, or sound as the first physical parameter, and to measure the presence or absence of liquid, in particular water, as the second physical parameter.

In some embodiments, the least one micro-mechanical sensing element is covered with a gel (e.g., silicone gel) coating. Gel coatings may be used to protect sensitive parts of the sensor from moisture and other environmental factors while maintaining the sensor's ability to detect and measure accurately. Gel coatings can conform to complex shapes of MEMS devices, providing comprehensive protection without interfering with mechanical movement or functionality of the sensor. This flexibility may ensure that even the most intricate parts of the sensor are shielded from water and moisture. Silicone gels and similar materials may provide durability and stability across a wide range of temperatures and environmental conditions. Gels can offer good resistance to chemicals, oils, and other substances that might damage the sensor. This chemical resistance may be crucial for sensors deployed in industrial or chemical processing environments. Gel coatings can provide electrical insulation, protecting the sensor's electrical components from short circuits due to water ingress while still allowing for accurate signal transmission. Natural damping properties of gel materials can protect MEMS sensors from shock and vibrations, which may be particularly beneficial for applications involving motion or impact, such as automotive systems or wearable devices.

In some embodiments, the at least one micro-mechanical sensing element forms at least one electrode of a capacitor of the MEMS sensor device. MEMS sensors may use capacitors as a fundamental part of their sensing mechanism. Capacitive sensing may be utilized in MEMS technology due to its high sensitivity, low power consumption, and straightforward integration with electronic circuits. In capacitive MEMS sensors, the capacitance (the ability of a system to store an electric charge) may change in response to the first physical parameter, such as pressure, acceleration, or displacement. This change in capacitance may then be measured and converted into an electrical signal that can be interpreted to determine the magnitude of the physical parameter being sensed. A stray or parasitic capacitance of the capacitor (and other components of the MEMS sensor device) may be used to measure the second physical parameter.

In some embodiments, the at least one micro-mechanical sensing element comprises a diaphragm. A diaphragm in a MEMS sensor is a thin, flexible membrane that can deform in response to external stimuli (and thus cause a change of capacitance). This deformation may then be measured and used to infer the magnitude of the stimulus, such as pressure differences or sound waves.

In some embodiments, the measurement circuitry is configured to measure the first physical parameter based on a deflection of the at least one micro-mechanical sensing element (e.g., diaphragm) caused by the first physical parameter, and to measure the second physical parameter based on an electric stray field between the micro-mechanical sensing element acting as a first electrode of a capacitor and a further component of the MEMS sensor device acting as a second electrode of the capacitor. The electric stray field is influenced by the second physical parameter (e.g., a material in proximity to the MEMS sensor device). An electric stray field can be influenced by a physical parameter, and this principle may be leveraged in various types of sensors, including those based on MEMS technology. Stray fields, which are unintended or parasitic electric fields that occur between components or parts of a circuit, can be affected by changes in physical conditions such as pressure, temperature, displacement, or the presence of a specific substance. In capacitive sensors, a physical change such as displacement, pressure, or the presence of a material with a different dielectric constant can alter the capacitance between two conductive plates. This is because these physical changes can modify the area of the plates that are facing each other, the distance between them, or the dielectric material in between, all of which influence the capacitance. For instance, the presence of a liquid with a high dielectric constant near a sensor can increase the capacitance, indicating the presence or quantity of the liquid.

In some embodiments, the further component of the MEMS sensor device comprises a second micro-mechanical sensing element (e.g., second capacitor), a lid (e.g., protective cover), and/or a substrate of the MEMS sensor device.

In some embodiments, the MEMS sensor device comprises a first micro-mechanical sensing element having a variable capacitance depending on the first physical parameter and a second micro-mechanical sensing element having a variable capacitance depending on the first physical parameter. The first micro-mechanical sensing element is arranged in a first branch of a Wheatstone bridge and the second micro-mechanical sensing element is arranged in a second branch of the Wheatstone bridge. The measurement circuitry is configured to, during the first operational mode, measure a voltage difference between middle nodes of the first and the second branch of the Wheatstone bridge, the voltage difference being indicative of the first physical parameter. The measurement circuitry is configured to, during the second operational mode, connect both terminals of the Wheatstone bridge to a common reference potential and measure a capacitance between the first micro-mechanical sensing element and the second micro-mechanical sensing element, the capacitance being indicative of the second physical parameter. In this way, the micro-mechanical sensing elements can be used to measure both the first physical parameter and the second physical parameter without increasing a part count of the MEMS sensor device.

In some embodiments, the measurement circuitry is configured to perform the first and the second operational mode according to a time-multiplexing scheme, e.g., successively. Alternatively, the measurement circuitry may be configured to perform the first and the second operational mode simultaneously, e.g., in parallel.

According to a further aspect, the present disclosure provides a wearable computing device comprising the MEMS sensor device of any one of the previous embodiments. A wearable computing device is a type of electronic device designed to be worn on the body, either as an accessory or as part of the material used in clothing. Examples include smartwatches, fitness trackers, smart glasses, smart clothing, etc.

According to yet a further aspect, the present disclosure provides sensing method. The sensing method includes, during a first operational mode of a MEMS sensor device, controlling at least one micro-mechanical sensing element of the MEMS sensor device to sense a first physical parameter. Dring a second operational mode of the MEMS sensor device, the at least one micro-mechanical sensing element is controlled to sense a different second physical parameter.

In some embodiments, the sensing method includes, during the first operational mode, electrically connecting the at least one micro-mechanical sensing element in accordance with a first electrical connection to sense the first physical parameter using the micro-mechanical sensing element, and, during the second operational mode, electrically connecting the at least one micro-mechanical sensing element in accordance with a different second electrical connection to sense the second physical parameter using the micro-mechanical sensing element.

In some embodiments, the first physical parameter is one of acceleration, pressure, motion, magnetic fields, or sound, and the second physical parameter is presence or absence of a material in proximity to the MEMS sensor device.

A key principle of the present disclosure is to reuse existing sensor (for example pressure sensor) structures to enable a material detection inside the sensor. This allows a contactless measurement of materials on top of the sensor, even if the sensor is covered for example by gel for environmental robustness. Therefore, also the sensing electrodes are protected against environmental effects which makes them more robust. Nevertheless, the electrodes can also be in direct contact with the material.

### Brief description of the Figures

Some examples of apparatuses and/or methods will be described in the following by way of example only, and with reference to the accompanying figures, in which
- Fig. 1: schematically illustrates a MEMS sensor device according to embodiment;
- Fig. 2: schematically illustrates a MEMS sensor device and a MEMS structure including an electric stray field to be evaluated;
- Fig. 3A,B: schematically shows example MEMS structures including protection gel as well as water droplet;
- Fig. 4: schematically shows a stacked MEMS sensor;
- Fig. 5A: first operational mode, circuit diagram of the ASIC including Reference Generator, MEMS bridge including to be measured capacitance Cmat, PGA and ADC
- Fig. 5B: second operational mode, circuit diagram of the ASIC including Reference Generator, MEMS bridge including to be measured capacitance Cmat, PGA and ADC
- Fig. 6: alternative circuit diagram to Fig. 5B;
- Fig. 7: illustrates how the micro-mechanical sensing elements of MEMs sensor may be connected to the two reference potentials and ground potential in the different operational modes;
- Fig. 8: schematically illustrates and example of a measurement between MEMS sub-strate and lid;
- Fig. 9A: measurement sequence of normal pressure mode (top) and mode including material sensing (bottom) in time-multiplexed manner; and
- Fig. 9B: measurement sequence of material sensing simultaneously to pressure sensing and/or temperature sensing.

### Detailed Description

Some examples are now described in more detail with reference to the enclosed figures. However, other possible examples are not limited to the features of these embodiments described in detail. Other examples may include modifications of the features as well as equivalents and alternatives to the features. Furthermore, the terminology used herein to describe certain examples should not be restrictive of further possible examples.

Throughout the description of the figures same or similar reference numerals refer to same or similar elements and/or features, which may be identical or implemented in a modified form while providing the same or a similar function. The thickness of lines, layers and/or areas in the figures may also be exaggerated for clarification.

When two elements A and B are combined using an "or", this is to be understood as disclosing all possible combinations, i.e. only A, only B as well as A and B, unless expressly defined otherwise in the individual case. As an alternative wording for the same combinations, "at least one of A and B" or "A and/or B" may be used. This applies equivalently to combinations of more than two elements.

If a singular form, such as "a", "an" and "the" is used and the use of only a single element is not defined as mandatory either explicitly or implicitly, further examples may also use several elements to implement the same function. If a function is described below as implemented using multiple elements, further examples may implement the same function using a single element or a single processing entity. It is further understood that the terms "include", "including", "comprise" and/or "comprising", when used, describe the presence of the specified features, integers, steps, operations, processes, elements, components and/or a group thereof, but do not exclude the presence or addition of one or more other features, integers, steps, operations, processes, elements, components and/or a group thereof.

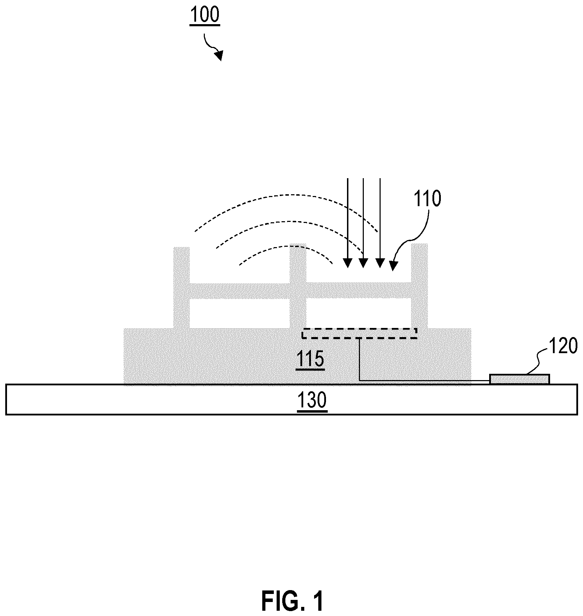

**Fig. 1** schematically illustrates a MEMS sensor device 100 in accordance with an embodiment of the present disclosure.

MEMS sensor device 100 comprises at least one micro-mechanical sensing element 110 and measurement circuitry 120 coupled to the micro-mechanical sensing element 110.

MEMS sensors may incorporate a variety of micro-mechanical sensing elements 110 that can detect and measure physical phenomena such as pressure, motion, acceleration, and environmental conditions. The micro-mechanical sensing element(s) 110 may be fabricated using microfabrication technology, enabling them to be highly sensitive, small in size, and compatible with electronic circuits for signal processing. Examples of micro-mechanical sensing elements 110 are cantilevers, i.e., thin, beam-like structures that are fixed at one end and free at the other. They can bend in response to forces such as pressure or chemical adsorption, making them useful in pressure sensors and chemical sensors. Another example for micro-mechanical sensing elements 110 are diaphragms, membrane-like structures that deflect when subjected to pressure differences across them. Diaphragms may be used in pressure sensors and microphones. Further examples of micro-mechanical sensing elements 110 include accelerometer masses attached to springs or beams that move relative to the rest of the sensor when accelerated, or gyroscopic structures that utilize the Coriolis effect to measure angular rate or orientation. Piezoresistive elements include materials whose resistance changes when they are mechanically deformed. By incorporating these materials into structures like cantilevers or beams, they can be used to measure force, pressure, or strain by measuring the change in electrical resistance.

The measurement circuitry 120 may be designed to interface with the micro-mechanical sensing element(s) 110 to capture, process, and convert physical quantities being measured into usable electrical signals, often in digital form. This circuitry may enable interpretation and utilization of the minute mechanical movements or changes within MEMS structures. The measurement circuitry 120 may include signal conditioning circuitry including amplifiers, filters, and other components necessary to amplify, filter, and otherwise modify the electrical signal generated by the micro-mechanical sensing element(s) 110 to make it suitable for further processing. The measurement circuitry 120 may comprise Analog-to-Digital Converter (ADC) circuitry. MEMS sensors may require an ADC to convert the conditioned analog signal into a digital format for digital processing, storage, or digital communication. The choice of ADC can affect the resolution, accuracy, and power consumption of the sensor. The measurement circuitry 120 may comprise interface circuitry that includes circuits required for communicating the sensor's data to other parts of the system, such as microcontrollers, processors, or external devices. Interface options can include SPI (Serial Peripheral Interface), I2C (Inter-Integrated Circuit), UART (Universal Asynchronous Receiver/Transmitter), and others, depending on the application's requirements. The measurement circuitry 120 may comprise power management circuitry, for example, including voltage regulators and power-on reset circuits to ensure stable operation under varying power conditions. The measurement circuitry 120 may comprise control logic circuits that manage the operation of the sensor, including timing control, gain control for amplifiers, calibration routines, and other functions that enhance the sensor's performance or ease of use. The measurement circuitry 120 may comprise reference voltage or current sources to maintain accuracy and stability. These references may be used in signal conditioning, ADC operations, and other parts of the measurement circuitry to ensure consistent performance.

During a first operational mode of the MEMS sensor device 100, the measurement circuitry 120 is configured to control the at least one micro-mechanical sensing element 110 to measure a first physical parameter or quantity, such as acceleration, pressure, motion, magnetic field, or sound. During a second operational mode of the MEMS sensor device 100, the measurement circuitry 120 is configured to control the micro-mechanical sensing element 110 to measure a different second physical parameter or quantity, such as a presence or absence of a material (e.g., liquid) in proximity to the MEMS sensor device.

Controlling the micro-mechanical sensing element 110 in the different operational modes may include respective different electrical connections of electrodes of the mechanical sensing element(s) 110 which lead to different measurement capabilities of the micro-mechanical sensing element(s) 110. Measurement circuitry 120 may be configured to, during the first operational mode, electrically connect the micro-mechanical sensing element(s) 110 in accordance with a first electrical connection to measure the first physical parameter using the micro-mechanical sensing element(s) 110. Further, measurement circuitry 120 may be configured to, during the second operational mode, electrically connect the micro-mechanical sensing element(s) 110 in accordance with a different second electrical connection to measure the second physical parameter using the micro-mechanical sensing element(s) 110. For example, the micro-mechanical sensing element(s) 110 may be used to measure one of acceleration, pressure, motion, magnetic field, or sound as the first physical parameter, and to measure the presence or absence of a liquid, in particular water, as the second physical parameter.

MEMS sensor device 100 comprises a substrate 130 carrying the at least one micro-mechanical sensing element 110 and the measurement circuitry 120. Substrate 130 may be a composite material (e.g., commonly FR-4) carrying micro-mechanical sensing element 110 and measurement circuitry 120. For example, substrate 130 may be a printed circuit bord (PCB). Micro-mechanical sensing element 110 also comprises a MEMS substrate 115 which may act as a physical foundation and electrical background for the sensor's structures. For example, silicon (Si) is a commonly used MEMS substrate material in MEMS sensors due to its well-understood properties, availability, and the mature technology for processing it. Depending on the application, substrates other than silicon, like glass, polymers, or ceramics, might be used depending on the specific requirements of the sensor application, such as flexibility, transparency, or biocompatibility.

While the principles of the present disclosure are not limited to capacitive MEMS sensor devices, the following description focusses, for illustrative purposes, on the micro-mechanical sensing element(s) 110 being configured for capacitive sensing. Thus, the at least one micro-mechanical sensing element 110 may form an electrode of a capacitor of the MEMS sensor device 100. For example, measurement circuitry 120 may be configured to, during the first operational mode of the MEMS sensor device 100, control the micro-mechanical sensing element(s) 110 to capacitively measure pressure as the first physical parameter.

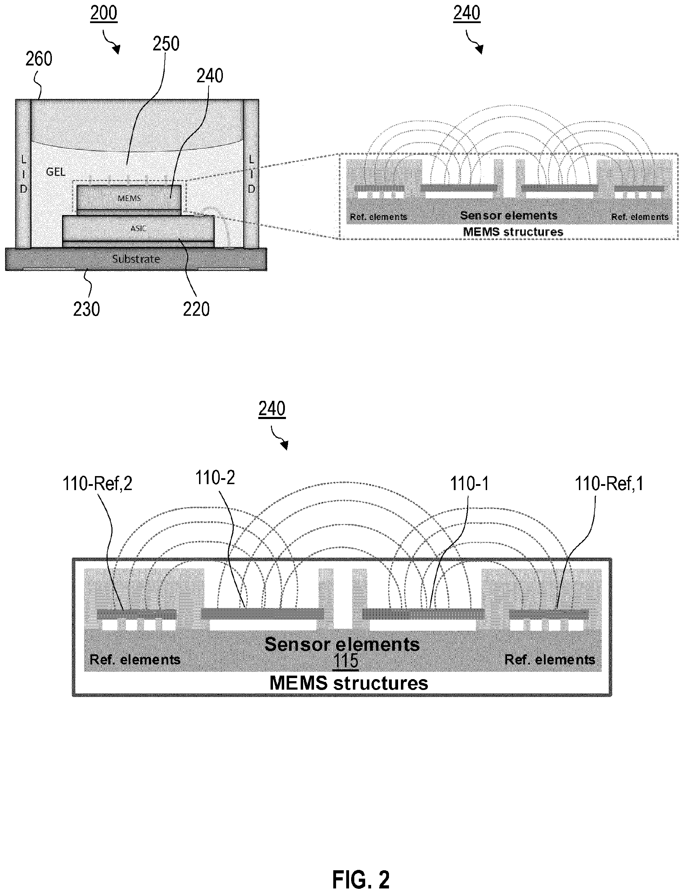

**Fig. 2** schematically illustrates an embodiment of a capacitive MEMS pressure sensor device 200.

MEMS pressure sensor device 200 comprises a substrate 230 (e.g., FR-4), e.g., a PCB. Disposed on the substrate 230 is an ASIC (Application-Specific Integrated Circuit) 220 together with a MEMs sensor 240. MEMS sensor 240 comprises at least one micro-mechanical sensing element 110 and may generate analog signals that represent measured physical quantities, such as pressure or sound. ASIC 220 may provide at least part of the measurement circuitry 120 and can process these analog signals, performing tasks like amplification, filtering, and conversion to digital form, making the data easier to use by digital systems. MEMS sensor 240 may require calibration to correct for manufacturing variances and compensation for environmental conditions like temperature changes. ASIC 220 can store calibration data and execute algorithms that adjust sensor outputs accordingly, enhancing accuracy. ASIC 220 may integrate data from multiple micro-mechanical sensing elements 110, process it, and communicate it to other parts of the system or to external systems. This may be useful in applications like smartphones, wearable devices, and IoT devices, where data from various sensors is collected and interpreted cohesively. MEMS sensors and their associated electronics often operate in power-constrained environments, such as battery-powered devices. ASIC 220 can thus include power management circuits that reduce power consumption, extend battery life, and manage power-on and power-off sequences for the sensors. Further, ASIC 220 may provide interfaces for the MEMS sensor 240 to communicate with other system components. These interfaces can include standard communication protocols such as I2C, SPI, UART, or proprietary interfaces designed for specific applications.

In the example shown in Fig. 2, ASIC 220 and MEMs sensor 240 are covered with a gel (e.g., silicone gel) coating 250 disposed within a lid 260 surrounding ASIC 220 and MEMs sensor 240. Gel coating 250 may be used to protect ASIC 220 and MEMs sensor 240 from moisture and other environmental factors while maintaining the MEMS pressure sensor device's 200 ability to detect and measure accurately. Lid 260 may provide a physical barrier that shields ASIC 220 and MEMs sensor 240 from mechanical stresses and shocks that could damage them during handling, assembly, or use. In applications where electromagnetic interference can affect sensor performance, lid 260 may be designed to provide electromagnetic interference (EMI) shielding.

The example MEMs sensor 240 comprises a plurality of MEMS structures comprising a first micro-mechanical reference sensing element 110-Ref,1, a second micro-mechanical reference sensing element 110-Ref,2, a first (main) micro-mechanical sensing element 110-1, and a second (main) micro-mechanical sensing element 110-2. Each of the micro-mechanical (reference) sensing elements 110 comprises a flexible membrane (diaphragm) suspended over a cavity. An example material for membranes is polysilicon being a polycrystalline form of silicon that may be used when a more flexible material compared to single-crystal silicon is required. Polysilicon can be deposited in thin layers, allowing for the fabrication of flexible membranes with good electrical properties.

The membrane of micro-mechanical sensing elements 110-1, 110-2 may deflect when external pressure is applied. The deflection changes the distance between the membrane and an opposing fixed electrode, forming a capacitor. The pressure-induced deflection changes the capacitance, which can be measured electronically. Temperature changes can affect the sensor by altering the membrane tension and the materials' properties, leading to measurement inaccuracies. The micro-mechanical reference sensing elements 110-Ref,1,2 may be designed to physically match the (main) micro-mechanical sensing elements 110-1,2 but without being sensitive to pressure changes. This may be achieved by creating a sealed cavity beneath the reference element's 110-Ref, 1,2 diaphragm so that it does not deflect significantly under pressure changes. This sealing may ensure that any capacitance changes in the reference elements 1 10-Ref,1,2 are primarily due to factors other than pressure, such as temperature.

The main micro-mechanical sensing elements 110-1,2 and reference sensing elements 110-Ref,1,2 may be connected in a differential configuration. This setup means that the electronic measurement circuit 220 may calculate a difference in capacitance between the respective main micro-mechanical sensing elements 110-1,2 and the reference micro-mechanical sensing elements 110-Ref,1,2. Since both elements are subjected to the same temperature and environmental conditions but only one responds to (external) pressure, subtracting the reference capacitance from the main sensor capacitance may cancel out the non-pressure-related effects, isolating the pressure signal.

MEMS pressure sensor device 200 is configured to measure (external) pressure as the first physical parameter based on a deflection of the membranes of the (main) micro-mechanical sensing elements 110-1,2 caused by the (external) pressure, and to measure the presence or absence of a liquid (e.g., water) on the gel coating 250 as the second physical parameter based on an electric stray field between the membranes of the (main) micro-mechanical sensing elements 110-1,2. Additionally, or alternatively, the presence or absence of the liquid (e.g., water) may be measured based on an electric stray field between the membranes acting as a first electrode of the capacitor of the (main) micro-mechanical sensing elements 110-1,2 and a further component (acting as a second electrode of the capacitor) of the MEMS pressure sensor device 200. The further component of the MEMS pressure sensor device 200 may be a membrane of the micro-mechanical reference sensing elements 110-Ref,1,2, a membrane of the second (main) micro-mechanical sensing element 110-2, the lid 260, and/or the substrate 230 of the MEMS pressure sensor device 200.

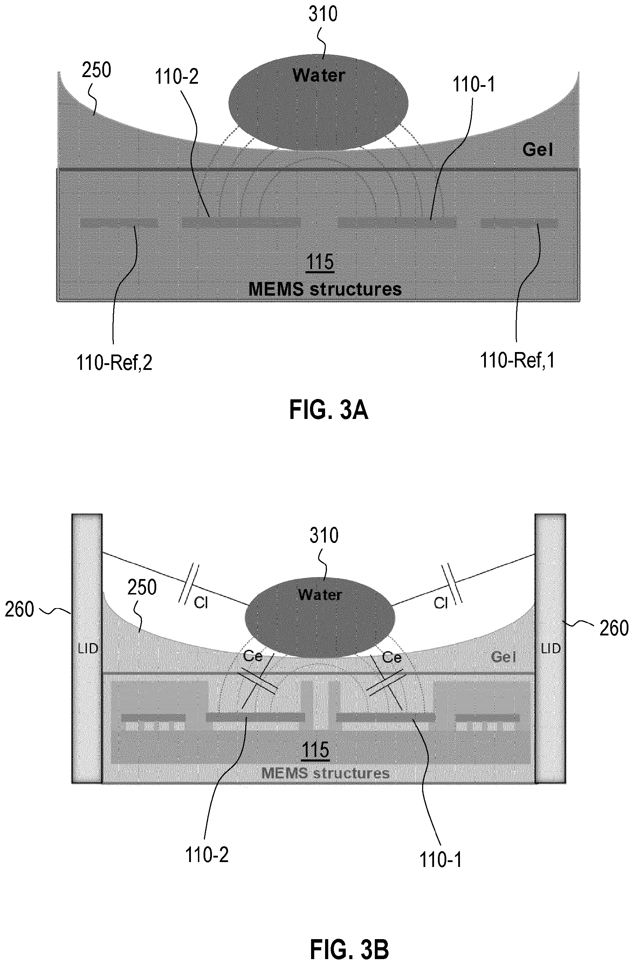

**Fig. 3A** shows an example where a water drop 310 is placed on top of the gel coating 250. The water drop 310 causes a measurable variation of the electric stray field between the membranes of the adjacent (main) micro-mechanical sensing elements 110-1, 2. The membranes of the adjacent (main) micro-mechanical sensing elements 110-1, 2 form a material sensing capacitor (Cmat). The variation of the electric stray field is also dependent on the gel thickness of the gel coating 250.

As shown in **Fig. 3B****,** the measured capacitance may include a capacitance (Ce) between the respective membranes (electrodes) of the adjacent micro-mechanical sensing elements 110-1, 2 and water drop 310 as well as a capacitance (Cl) between water drop 310 and lid 260. Therefore, a measured capacitance may decrease when material (e.g., water) is added in proximity to the MEMs sensor 240. With this approach, the material detection sensitivity can be increased by also considering the capacitance towards the lid 260 and not only between the membranes (electrodes) of the adjacent micro-mechanical sensing elements 110-1, 2. With very thin gel thicknesses (below approx. 100 µm) Ce may be dominant. With thicker gels, Cl may become dominant and improve sensitivity.

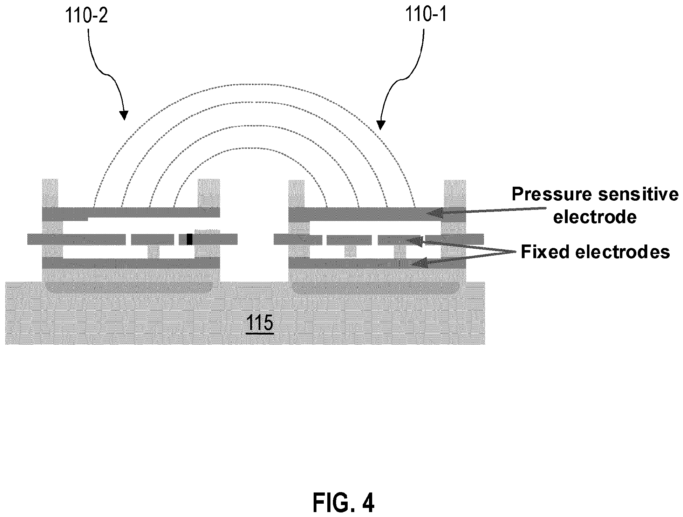

As schematically illustrated in **Fig. 4****,** the proposed approach can also be used for stacked MEMS sensors. A stacked MEMS sensor refers to a design and fabrication approach where multiple layers of MEMS structures or a MEMS layer and an integrated circuit (IC) layer, such as an ASIC, are vertically integrated or "stacked" atop one another. This method is also known as 3D integration in the context of microelectronics and MEMS fabrication. Stacked MEMS sensors are a trend towards more compact, efficient, and high-performance microsystems that combine mechanical and electrical components in a minimal footprint. By stacking components vertically, these sensors may use space more efficiently than traditional, planar designs. This may be particularly advantageous in applications where footprint is at a premium, such as smartphones, wearable devices, and medical implants. Stacking may allow for the close integration of MEMS sensing elements with their requisite electronic processing units (e.g., ASICs for signal conditioning, processing, and communication). This proximity can reduce signal transmission losses and noise, enhancing overall sensor performance.

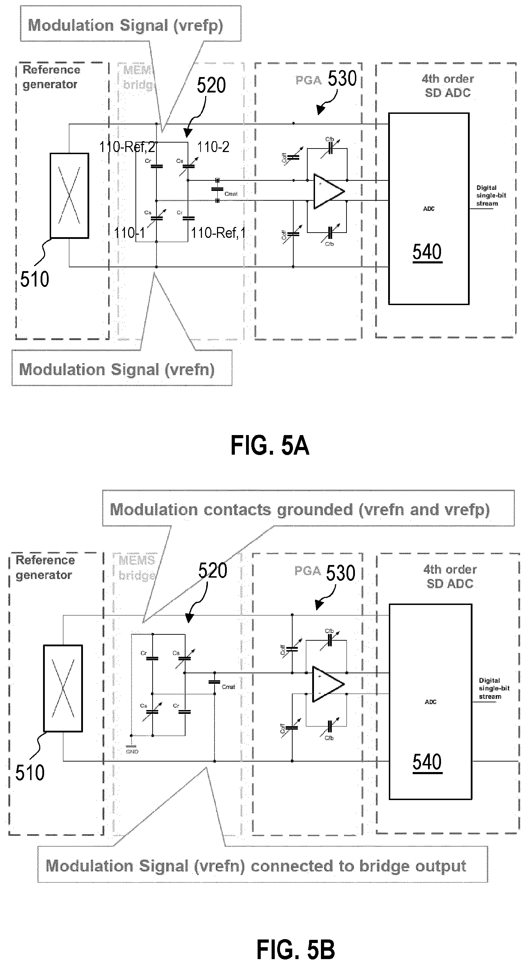

**Fig. 5A** shows an example of the measurement circuit 120 of MEMS pressure sensor device 200 in a first operational mode for pressure sensing.

As explained in the previous Figs., MEMS pressure sensor device 200 comprises the first micro-mechanical sensing element 110-1 having a first variable capacitance (Cs) depending on (external) pressure and the second micro-mechanical sensing element 110-2 having a second variable capacitance (Cs) depending on the (external) pressure. Further, MEMS pressure sensor device 200 comprises the first micro-mechanical reference sensing element 110-Ref,1 having a first reference capacitance (Cr) not depending on the (external) pressure and the second micro-mechanical reference sensing element 110-Ref,2 having a second reference capacitance (Cr) not depending on the (external) pressure.

As shown in Fig. 5A, measurement circuit 120 comprises a Wheatstone bridge (MEMS bridge) 520 connected between a first reference potential (vrefp) and a second reference potential (vrefn). The first reference potential (vrefp) and the second reference potential (vrefn) are generated by reference generator circuit 510. The Wheatstone bridge (MEMS bridge) 520 is an electrical circuit used for precise measurement of electrical impedances. Wheatstone bridge 520 has four impedances arranged in a diamond shape, with an excitation voltage applied across one diagonal and an output voltage measured across the other. By connecting the bridge 520 between two reference potentials (vrefp, vrefn), the bridge's output becomes a differential voltage relative to vrefp and vrefn. This differential measurement can reduce noise and increase the accuracy of the sensor reading, as common-mode noise may be rejected by the measurement system. Having two reference potentials (vrefp, vrefn) allows for more flexibility in setting the operating range of the Wheatstone bridge 520. This can be particularly useful in battery-powered applications (e.g., smartwatches), where the available power supply voltage may vary over time, or in applications requiring compatibility with other system voltage levels.

A first branch of the Wheatstone bridge 520 comprises a series connection of the second micro-mechanical reference sensing element 110-Ref,2 (Cr) and the first main micro-mechanical sensing element 110-1 (Cs). A second branch of the Wheatstone bridge 520 comprises a series connection of the second main micro-mechanical sensing element 110-2 (Cs) and the first micro-mechanical reference sensing element 110-Ref,1 (Cr).

In the first operational mode for pressure sensing (Fig. 5A), the second micro-mechanical reference sensing element 1 10-Ref,2 (Cr) is coupled between the first reference potential (vrefp) and the first main micro-mechanical sensing element 110-1 (Cs). The first main micro-mechanical sensing element 110-1 (Cs) is coupled between the second micro-mechanical reference sensing element 110-Ref,2 (Cr) and the second reference potential (vrefn). In the first operational mode, the second main micro-mechanical sensing element 110-2 (Cs) is coupled between the first reference potential (vrefp) and the first micro-mechanical reference sensing element 110-Ref,1 (Cr). The first micro-mechanical reference sensing element 110-Ref,1 (Cr) is coupled between the second main micro-mechanical sensing element 110-2 (Cs) and the second reference potential (vrefn).

A first output node (terminal) of the Wheatstone bridge 520 is between the second micro-mechanical reference sensing element 110-Ref,2 (Cr) and the first main micro-mechanical sensing element 110-1 (Cs). A second output node (terminal) of the Wheatstone bridge 520 is between the second main micro-mechanical sensing element 110-2 (Cs) and the first micro-mechanical reference sensing element 110-Ref,1 (Cr). An electrode (membrane) of the first main micro-mechanical sensing element 110-1 (Cs) and corresponding to the first node output and an electrode (membrane) of the second main micro-mechanical sensing element 110-2 (Cs) and corresponding to the second node form a material sensing capacitance (Cmat) between the first and second output node. In the first operational mode for pressure sensing, a pressure dependent voltage between the first and the second output node are measured.

In the first operational mode for pressure sensing (Fig. 5A), the first and second output nodes of Wheatstone bridge 520 are coupled to input nodes of a differential programmable gain amplifier (PGA) circuit 530, differential output terminals of which are coupled to an analog-to-digital converter (ADC) circuit 540. PGA circuit 530 comprises a first (inverting) input node of an operational amplifier coupled to the first output node of Wheatstone bridge 520, and a second (non-inverting) input node of the operational amplifier coupled to the second output node of Wheatstone bridge 520.The first (inverting) input node of PGA circuit 530 is coupled to the second reference potential (vrefn) via a first adjustable capacitor (Coff). The second (non-inverting) input node of PGA circuit 530 is coupled to the first reference potential (vrefp) via a second adjustable capacitor (Coff). A first (inverting) output node of PGA circuit 530 is coupled to the first (inverting) input node of PGA circuit 530 via a first adjustable feedback capacitor (Cfb). A second (non-inverting) output node of PGA circuit 530 is coupled to the second (non-inverting) input node of PGA circuit 530 via a second adjustable feedback capacitor (Cfb).

ADC circuit 540 may comprise a 4^{th} order sigma-delta ADC, for example. The skilled person having benefit from the present disclosure will appreciate that alternate implementations are possible. A 4th order sigma-delta (Σ-Δ) ADC is a type of analog-to-digital conversion technology that uses a sigma-delta modulation process with a loop filter of 4th order in its feedback loop. The order of a sigma-delta ADC refers to the order of the loop filter used in the modulator; a 4th order modulator has a loop filter that is mathematically represented by a 4th degree polynomial. This higher-order loop filter allows for more aggressive noise shaping, effectively pushing more of the quantization noise out of the band of interest, which for most applications means improved resolution and dynamic range within the signal bandwidth.

During the first operational mode, the measurement circuitry 120 is configured to measure a voltage difference between the first and second output nodes of Wheatstone bridge 520. The voltage difference is indicative of the first physical parameter (e.g., external pressure).

**Fig. 5B** shows the measurement circuit 120 of MEMS pressure sensor device 200 in a second operational mode for material (liquid) sensing.

In the second operational mode, the second micro-mechanical reference sensing element 110-Ref,2 (Cr) is coupled between ground potential (GND) and the first output node of the first branch. The first main micro-mechanical sensing element 110-1 (Cs) is coupled between the first (output) node and ground potential (GND). The first output node of the first branch is connected to the second reference potential (vrefn). Further in the second operational mode, the second main micro-mechanical sensing element 110-2 (Cs) is coupled between ground potential (GND) and the second output node of the second branch. The first micro-mechanical reference sensing element 110-Ref,1 (Cr) is coupled between the second output node and ground potential (GND). The second output node of the second branch of Wheatstone bridge 520 is coupled to the second (non-inverting) input terminal of PGA circuit 530. The first (inverting) input terminal of PGA circuit 530 is coupled to the to the second reference potential (vrefn) via the first adjustable capacitor (Coff). The first (inverting) input terminal of PGA circuit 530 is not connected to the first output node of Wheatstone bridge 520. Again, an electrode (membrane) of the first main micro-mechanical sensing element 110-1 (Cs) and corresponding to the first output node output and an electrode (membrane) of the second main micro-mechanical sensing element 110-2 (Cs) and corresponding to the second output node form the material sensing capacitance (Cmat) between the first and second node.

Thus, during the second operational mode, both terminals of the Wheatstone bridge 520 are connected to a common reference potential (GND) and the material sensing capacitance (Cmat) between the first micro-mechanical sensing element 110-1 and the second micro-mechanical sensing element 110-2 is measured using the PGA circuit 530. The material sensing capacitance (Cmat) is indicative of the second physical parameter (e.g., presence or absence of water in proximity to the MEMS sensor device 200).

The reconnections between the first and the second operational mode may be done using a multiplexer (e.g., inside ASIC). The multiplexer can route signals from different sources to a single destination. By changing the selection inputs, one can dynamically change which source is connected to the destination.

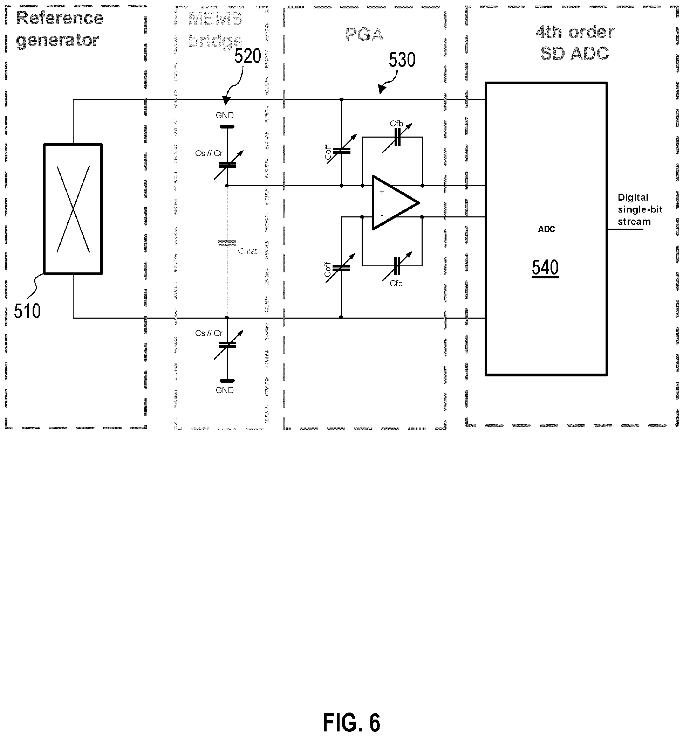

An alternative, simplified circuit diagram of the second operational mode is shown in **Fig. 6****.**

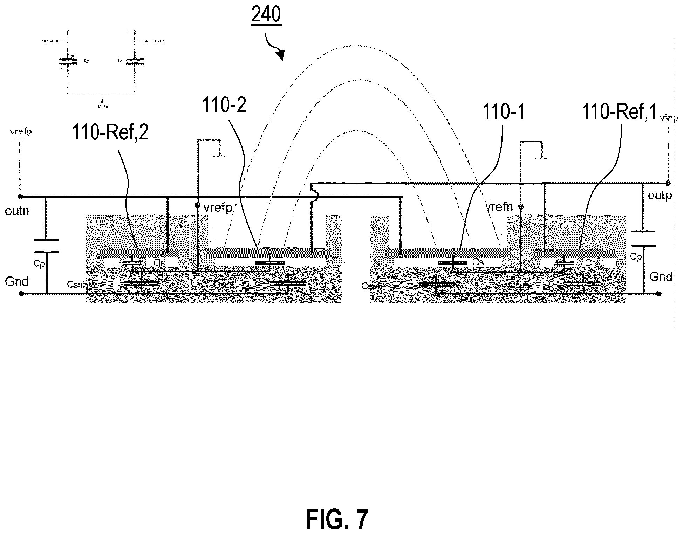

**Fig. 7** illustrates how the micro-mechanical sensing elements of MEMs sensor 240 may be connected to the two reference potentials (vrefp, vrefn) and ground potential (GND) in the different operational modes.

In the first operational mode, the lower (fixed) electrodes of micro-mechanical sensing elements 110-2 and 110-Ref,2 may be connected to the first reference potential (vrefp). The upper electrode (membrane) of second micro-mechanical reference sensing element 110-Ref,2 may be connected, via first output node, to the upper electrode (membrane) of first main micro-mechanical sensing element 110-1 (Cs). The upper electrode (membrane) of second main micro-mechanical sensing element 110-2 (Cs) may be connected, via second output node, to the upper electrode (membrane) of first micro-mechanical reference sensing element 110-Ref,1. The lower (fixed) electrodes of micro-mechanical sensing elements 110-1 and 110-Ref,1 may be connected to the second reference potential (vrefn).

In the second operational mode, the lower (fixed) electrodes of micro-mechanical sensing elements 110-2 and 110-Ref,2 may be connected to ground potential (GND). The upper electrode (membrane) of second micro-mechanical reference sensing element 110-Ref,2 may be connected, via ground potential (GND), to the upper electrode (membrane) of first main micro-mechanical sensing element 110-1 (Cs). The upper electrode (membrane) of second main micro-mechanical sensing element 110-2 (Cs) may be connected, via second output node, to the upper electrode (membrane) of first micro-mechanical reference sensing element 110-Ref,1. The lower (fixed) electrodes of micro-mechanical sensing elements 110-1 and 110-Ref,1 may be connected to ground potential (GND).

In an example implementation, the material sensing capacitance (Cmat) between the membranes of main micro-mechanical sensing elements 110-1, 110-2 may be below 50 fF. The pressure sensitive capacitances Cs may be approx. 3.5 pF. Reconnection of the MEMS bridge 520 may be done by an additional input multiplexer (not shown in this image) inside the ASIC.

For the readout of the capacitance / impedance, either dedicated circuits can be used, or existing circuits be reused, depending on the type of sensor and the required accuracy of the material sensing. This enables a basic material sensing without any external components as well as without any additional circuitry (analog frontend, still additional circuitry inside the main logic is required) on the readout ASIC.

Potential variations of the material (e.g., water) sensing result based on the main micro-mechanical sensing element(s) output can be compensated based on the main pressure sensor signal. For example, based on a pressure sensor, the top membrane (which is used for the pressure sensing) will be deformed based on the surrounding pressure. This deformation will have an impact on the capacitance used for material detection. Since the pressure information is available as well, this effect can be compensated.

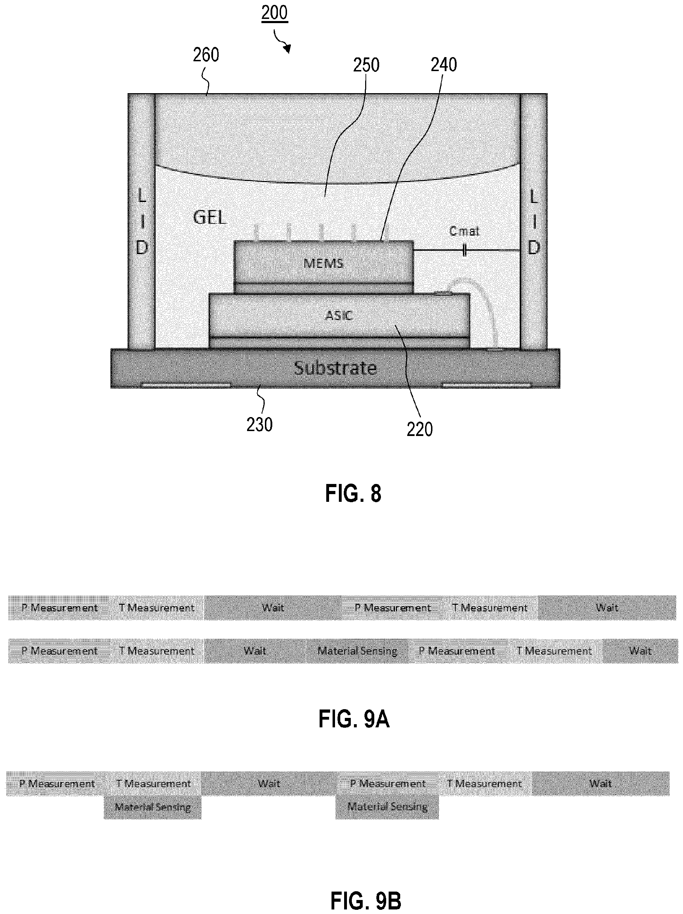

In addition to the two micro-mechanical sensing elements 110-1, 110-2 on the MEMS sensor 240, the substrate 220 of the MEMS device 200 itself can be reused for material detection. **Fig. 8** shows such an example where Cmat is the material sensing capacitance to be measured. If material is positioned on top of the gel 250, the capacitance between the MEMS substrate 220 and lid 260 will be influenced. Such a concept allows higher sensitivity in terms of to be detected material. Nevertheless, it requires additional circuitry for capacitance measurements because in typical applications, the lid 260 may be grounded. Therefore, the capacitance needs to be measured on one side only (for example with an RC or ring oscillator).

As illustrated in **Fig. 9A****,** a typical pressure sensor can be configured so that for example a sequence of pressure and temperature (P and T) measurements are done in a sequence at a given rate. Now, on certain slots inside this sequence, a material sensing measurement can be added. Pressure, temperature, and material sensing measurement are time multiplexed. By adequate dimensioning of a wait time, this can be done in a way so that the overall sequence of pressure and temperature measurements can be kept at a given measurement rate. Also the measurement time for material sensing can be chosen as a tradeoff between accuracy and measurement time / power consumption.

Thus, the material sensing measurement can be included inside an existing measurement cycle. The sequence in Fig. 9A sketches a potential pressure sensor measurement cycle with (Fig. 9A, bottom) and without (Fig. 9A, top) material sensing. Typically, P measurement is done in every cycle and T as well as material depending on the required measurement rate. Wait times and measurement rates of R and material measurements can be adapted according to specific needs.

Alternatively, the measurement circuitry 120 may be configured to perform material sensing measurement simultaneously, e.g., in parallel, to pressure and/or temperature sensing. This is schematically illustrated in **Fig. 9B****.**

Core or the proposed solution is to reuse existing MEMS structures of the sensor (for example pressure) as electrodes for material sensing. The structures do not need to be additional dedicated structures (like metal electrodes). Existing sensor structures like poly membranes can be reused. This avoids additional structures on the MEMS as well as bond wires (area and cost improvements). Effects (for example due to pressor deforming MEMS structures) can be directly compensated since this is the main output of the pressure sensor. Also the whole MEMS substrate itself can be used as electrode and capacitance measured against any other structure inside the sensor, like the conductive lid.

Both concepts are based on existing MEMS structures as compared to physical electrodes. The material sensing can be measured in a sequence together with the main sensor signal (for example pressure) but also in parallel, depending on the readout circuitry and used sensing concept.

Key principle of the proposed solution is to reuse existing sensor (for example pressure sensor) structures to enable a material detection inside the sensor. This allows a contactless measurement of materials on top of the sensor, even if the sensor is covered for example by gel for environmental robustness. Therefore, also the sensing electrodes are protected against environmental effects which makes them more robust. Nevertheless, the electrodes can also be in direct contact with the material.

The proposed solution may be used for water detection that can be performed with existing MEMS and ASIC by just adding little complexity to the ASIC (interface reconfiguration with switches) and uses the same main signal processing hardware (capacitive to digital converter) that is already used for the pressure measurement.

The aspects and features described in relation to a particular one of the previous examples may also be combined with one or more of the further examples to replace an identical or similar feature of that further example or to additionally introduce the features into the further example.

Examples may further be or relate to a (computer) program including a program code to execute, when the program is executed on a computer, processor or other programmable hardware component, a method of, during a first operational mode of a MEMS sensor device, controlling at least one micro-mechanical sensing element of the MEMS sensor device to sense a first physical parameter, and, during a second operational mode of the MEMS sensor device, controlling the at least one micro-mechanical sensing element to sense a different second physical parameter. Thus, steps, operations or processes of different ones of the methods described above may also be executed by programmed computers, processors or other programmable hardware components. Examples may also cover program storage devices, such as digital data storage media, which are machine-, processor- or computer-readable and encode and/or contain machine-executable, processor-executable or computer-executable programs and instructions. Program storage devices may include or be digital storage devices, magnetic storage media such as magnetic disks and magnetic tapes, hard disk drives, or optically readable digital data storage media, for example. Other examples may also include computers, processors, control units, (field) programmable logic arrays ((F)PLAs), (field) programmable gate arrays ((F)PGAs), graphics processor units (GPU), application-specific integrated circuits (ASICs), integrated circuits (ICs) or system-on-a-chip (SoCs) systems programmed to execute the steps of the methods described above.

It is further understood that the disclosure of several steps, processes, operations or functions disclosed in the description or claims shall not be construed to imply that these operations are necessarily dependent on the order described, unless explicitly stated in the individual case or necessary for technical reasons. Therefore, the previous description does not limit the execution of several steps or functions to a certain order. Furthermore, in further examples, a single step, function, process or operation may include and/or be broken up into several sub-steps, - functions, -processes or -operations.

If some aspects have been described in relation to a device or system, these aspects should also be understood as a description of the corresponding method. For example, a block, device or functional aspect of the device or system may correspond to a feature, such as a method step, of the corresponding method. Accordingly, aspects described in relation to a method shall also be understood as a description of a corresponding block, a corresponding element, a property or a functional feature of a corresponding device or a corresponding system.

The following claims are hereby incorporated in the detailed description, wherein each claim may stand on its own as a separate example. It should also be noted that although in the claims a dependent claim refers to a particular combination with one or more other claims, other examples may also include a combination of the dependent claim with the subject matter of any other dependent or independent claim. Such combinations are hereby explicitly proposed, unless it is stated in the individual case that a particular combination is not intended. Furthermore, features of a claim should also be included for any other independent claim, even if that claim is not directly defined as dependent on that other independent claim.

The person skilled in the art will appreciate that the scope of the present disclosure is not limited to the embodiments explicitly described herein. Various modifications and improvements can be made to these embodiments without departing from the scope of the disclosure as outlined in the claims. Such modifications are intended to be within the scope of the invention as defined by the following claims.

## Claims

1. A MEMS sensor device (100; 200), comprising
at least one micro-mechanical sensing element (110);
measurement circuitry (120; 510; 520; 530) coupled to the at least one micro-mechanical sensing element (110),
wherein the measurement circuitry (120; 510; 520; 530) is configured to,
during a first operational mode of the MEMS sensor device (100; 200),
control the at least one micro-mechanical sensing element (110) to measure a first physical parameter, and
during a second operational mode of the MEMS sensor device (100; 200),
control the at least one micro-mechanical sensing element (110) to measure a different second physical parameter.

2. The MEMS sensor device (100; 200) of claim 1,
wherein the measurement circuitry (120; 510; 520; 530) is configured to,
during the first operational mode,
electrically connect the at least one micro-mechanical sensing element in accordance with a first electrical connection to measure the first physical parameter using the micro-mechanical sensing element, and
during the second operational mode,
electrically connect the at least one micro-mechanical sensing element in accordance with a different second electrical connection to measure the second physical parameter using the micro-mechanical sensing element.

3. The MEMS sensor device (100; 200) of claim 1 or 2,
wherein the measurement circuitry (120; 510; 520; 530) is configured to,
during the first operational mode,
measure one of acceleration, pressure, motion, magnetic field, or sound as the first physical parameter, and
during the second operational mode,
measure a presence or absence of a material in proximity to the MEMS sensor device as the second physical parameter.

4. The MEMS sensor (100; 200) device of claim 3, wherein the material comprises a liquid, in particular water.

5. The MEMS sensor device (100; 200) of any one of the previous claims, wherein the least one micro-mechanical sensing element (110) is covered with a gel coating (250).

6. The MEMS sensor device (100; 200) of any one of the previous claims, wherein the at least one micro-mechanical sensing element (110) forms at least one electrode of a capacitor of the MEMS sensor device (100; 200).

7. The MEMS sensor device (100; 200) of any one of the previous claims, wherein the at least one micro-mechanical sensing element (110) comprises a diaphragm.

8. The MEMS sensor device (100; 200) of any one of the previous claims,
wherein the measurement circuitry (120; 510; 520; 530) is configured to
measure the first physical parameter based on a deflection of the at least one micro-mechanical sensing element caused by the first physical parameter, and
measure the second physical parameter based on an electric stray field between the micro-mechanical sensing element acting as a first electrode of a capacitor and a further component of the MEMS sensor device acting as a second electrode of the capacitor, wherein the electric stray field is influenced by the second physical parameter.

9. The MEMS sensor device (100; 200) of claim 8, wherein the further component of the MEMS sensor device (100; 200) comprises a second micro-mechanical sensing element, a lid (260), and/or a substrate (120; 220) of the MEMS sensor device (100; 200).

10. The MEMS sensor device (100; 200) of any one of the previous claims, comprising
a first micro-mechanical sensing element (110-1) having a variable capacitance depending on the first physical parameter;
a second micro-mechanical sensing (110-2) element having a variable capacitance depending on the first physical parameter;
wherein the first micro-mechanical sensing element (110-1) is arranged in a first branch of a Wheatstone bridge (520) and the second micro-mechanical sensing element (110-2) is arranged in a second branch of the Wheatstone bridge (520);
wherein the measurement circuitry (120; 510; 520; 530) is configured to,
during the first operational mode,
measure a voltage difference between middle nodes of the first and the second branch of the Wheatstone bridge (520), the voltage difference being indicative of the first physical parameter, and
during the second operational mode,
connect both terminals of the Wheatstone bridge (520) to a common reference potential and measure a capacitance between the first micro-mechanical sensing element (110-1) and the second micro-mechanical sensing element (110-2), the capacitance being indicative of the second physical parameter.

11. The MEMS sensor device (100; 200) of any one of the previous claims, wherein the measurement circuitry (120; 510; 520; 530) is configured to perform the first and the second operational mode according to a time-multiplexing scheme or to perform the first and the second operational mode simultaneously.

12. A wearable computing device comprising the MEMS sensor device (100; 200) of any one of the previous claims.

13. A sensing method, comprising
during a first operational mode of a MEMS sensor device,
controlling at least one micro-mechanical sensing element of the MEMS sensor device to sense a first physical parameter; and
during a second operational mode of the MEMS sensor device,
controlling the at least one micro-mechanical sensing element to sense a different second physical parameter.

14. The sensing method of claim 13, comprising
during the first operational mode,
electrically connecting the at least one micro-mechanical sensing element in accordance with a first electrical connection to sense the first physical parameter using the micro-mechanical sensing element, and
during the second operational mode,
electrically connecting the at least one micro-mechanical sensing element in accordance with a different second electrical connection to sense the second physical parameter using the micro-mechanical sensing element.

15. The sensing method of claim 13 or 14, wherein the first physical parameter is one of acceleration, pressure, motion, magnetic fields, or sound, and the second physical parameter is presence or absence of a material in proximity to the MEMS sensor device.

## Amended claims

### Amended claims in accordance with Rule 137(2) EPC.

1. A MEMS sensor device (100; 200), comprising
at least one micro-mechanical sensing element (110);
measurement circuitry (120; 510; 520; 530) coupled to the at least one micro-mechanical sensing element (110),
wherein the measurement circuitry (120; 510; 520; 530) is configured to,
during a first operational mode of the MEMS sensor device (100; 200),
control the at least one micro-mechanical sensing element (110) to measure a first physical parameter, and
during a second operational mode of the MEMS sensor device (100; 200),
control the at least one micro-mechanical sensing element (110) to measure a different second physical parameter,
wherein the measurement circuitry (120; 510; 520; 530) is configured to,
during the first operational mode,
measure one of acceleration, pressure, motion, magnetic field, or sound as the first physical parameter, and
during the second operational mode,
measure a presence or absence of a material in proximity to the MEMS sensor device as the second physical parameter.

2. The MEMS sensor device (100; 200) of claim 1,
wherein the measurement circuitry (120; 510; 520; 530) is configured to,
during the first operational mode,
electrically connect the at least one micro-mechanical sensing element in accordance with a first electrical connection to measure the first physical parameter using the micro-mechanical sensing element, and
during the second operational mode,
electrically connect the at least one micro-mechanical sensing element in accordance with a different second electrical connection to measure the second physical parameter using the micro-mechanical sensing element.

3. The MEMS sensor (100; 200) device of any one of the previous claims, wherein the material comprises a liquid, in particular water.

4. The MEMS sensor device (100; 200) of any one of the previous claims, wherein the least one micro-mechanical sensing element (110) is covered with a gel coating (250).

5. The MEMS sensor device (100; 200) of any one of the previous claims, wherein the at least one micro-mechanical sensing element (110) forms at least one electrode of a capacitor of the MEMS sensor device (100; 200).

6. The MEMS sensor device (100; 200) of any one of the previous claims, wherein the at least one micro-mechanical sensing element (110) comprises a diaphragm.

7. The MEMS sensor device (100; 200) of any one of the previous claims,
wherein the measurement circuitry (120; 510; 520; 530) is configured to
measure the first physical parameter based on a deflection of the at least one micro-mechanical sensing element caused by the first physical parameter, and
measure the second physical parameter based on an electric stray field between the micro-mechanical sensing element acting as a first electrode of a capacitor and a further component of the MEMS sensor device acting as a second electrode of the capacitor, wherein the electric stray field is influenced by the second physical parameter.

8. The MEMS sensor device (100; 200) of claim 7, wherein the further component of the MEMS sensor device (100; 200) comprises a second micro-mechanical sensing element, a lid (260), and/or a substrate (120; 220) of the MEMS sensor device (100; 200).

9. The MEMS sensor device (100; 200) of any one of the previous claims, comprising
a first micro-mechanical sensing element (110-1) having a variable capacitance depending on the first physical parameter;
a second micro-mechanical sensing (110-2) element having a variable capacitance depending on the first physical parameter;
wherein the first micro-mechanical sensing element (110-1) is arranged in a first branch of a Wheatstone bridge (520) and the second micro-mechanical sensing element (110-2) is arranged in a second branch of the Wheatstone bridge (520);
wherein the measurement circuitry (120; 510; 520; 530) is configured to,
during the first operational mode,
measure a voltage difference between middle nodes of the first and the second branch of the Wheatstone bridge (520), the voltage difference being indicative of the first physical parameter, and
during the second operational mode,
connect both terminals of the Wheatstone bridge (520) to a common reference potential and measure a capacitance between the first micro-mechanical sensing element (110-1) and the second micro-mechanical sensing element (110-2), the capacitance being indicative of the second physical parameter.

10. The MEMS sensor device (100; 200) of any one of the previous claims, wherein the measurement circuitry (120; 510; 520; 530) is configured to perform the first and the second operational mode according to a time-multiplexing scheme or to perform the first and the second operational mode simultaneously.

11. A wearable computing device comprising the MEMS sensor device (100; 200) of any one of the previous claims.

12. A sensing method, comprising
during a first operational mode of a MEMS sensor device,
controlling at least one micro-mechanical sensing element of the MEMS sensor device to sense a first physical parameter; and
during a second operational mode of the MEMS sensor device,
controlling the at least one micro-mechanical sensing element to sense a different second physical parameter,
wherein the first physical parameter is one of acceleration, pressure, motion, magnetic fields, or sound, and the second physical parameter is presence or absence of a material in proximity to the MEMS sensor device.

13. The sensing method of claim 12, comprising
during the first operational mode,
electrically connecting the at least one micro-mechanical sensing element in accordance with a first electrical connection to sense the first physical parameter using the micro-mechanical sensing element, and
during the second operational mode,
electrically connecting the at least one micro-mechanical sensing element in accordance with a different second electrical connection to sense the second physical parameter using the micro-mechanical sensing element.
